Europäisches Patentamt

European Patent Office

Office européen des brevets

(19)

(11) Veröffentlichungsnummer: **0 148 395**
**B1**

(12) **EUROPÄISCHE PATENTSCHRIFT**

(45) Veröffentlichungstag der Patentschrift: 06.02.91

(21) Anmeldenummer: 84114456.1

(22) Anmeldetag: 29.11.84

(51) Int. Cl.⁵: **H 04 Q 3/52, H 03 K 17/62**

(54) Breitbandkoppelfeld in Matrixform.

(30) Priorität: 05.01.84 DE 3400217

(43) Veröffentlichungstag der Anmeldung:
17.07.85 Patentblatt 85/29

(45) Bekanntmachung des Hinweises auf die
Patenterteilung:
06.02.91 Patentblatt 91/06

(84) Benannte Vertragsstaaten:
DE FR GB NL SE

(56) Entgegenhaltungen:
DE-A-2 451 728
DE-A-3 215 176
US-A-3 550 087
US-A-3 636 384

IEEE JOURNAL OF SOLID-STATE CIRCUITS,
Band SC-10, Nr. 2, April 1975, Seiten 117-122,
New York, US; M. SUNAZAWA et al.: "Low
power CML IC crosspoint switch matrix for
space division digital switching networks"

(73) Patentinhaber: ANT Nachrichtentechnik GmbH
Gerberstrasse 33
D-7150 Backnang (DE)

(72) Erfinder: Rein, Hans Martin, Dr.
Ein Bäumchen 6
D-5810 Witten 3 (DE)

(56) Entgegenhaltungen:
INTERNATIONAL SWITCHING SYMPOSIUM,
Montreal, 21.-25. September 1981, "Session 21
B", "Paper 5", Seiten 1-7; R.E. CARDWELL et al.:
"Experimental wideband switching system
capability"

NACHRICHTENTECHNISCHE ZEITSCHRIFT,
Band 29, Nr. 10, Oktober 1976, Seiten 756-761,
Berlin, DE; H. KLIEM: "Eine
Breitbandkoppelanordnung mit integrierten
elektronischen Koppelpunkten"

Courier Press, Leamington Spa, England.

EP 0 148 395 B1

**Beschreibung**

Die Erfindung betrifft ein Breitbandkoppelfeld gemäß dem Oberbegriff des Patentanspruchs 1. Ein solches Koppelfeld ist bekannt aus EP 24 027 A1 (entspricht DE 29 32 587 A1).

Die Koppelpunktschaltkreise dieses Koppelfeldes in ECL-Technik bestehen dort jeweils aus Differenzverstärkertufen, in deren Emitterzweig ein Gegenkopplungswiderstand sowie ein Transistor eingefügt ist. Dieser Transistor wird an seiner Basis mit einem Steuersignal zum Durchschalten oder Öffnen des Koppelpunktes beaufschlagt. Diesen Differenzverstärkern müssen zusätzliche Referenzsignale zugeführt werden. Das Koppelfeld der EP 24 027 A1 weist außerdem eine für manche Anwendungsfälle ungenügende Entkopplung zwischen den Signalleitungen in Zeilen- und Spaltenrichtung auf. Es ist bei diesem Koppelfeld nicht ohne weiteres möglich, mehrere Koppelpunkte einer Spalte zu Gruppen zusammenzufassen und auf eine Ausgangsstufe zu schalten.

Aus der EP 56 949 A1 ist ein Breitband-Koppelfeld in Matrixform bekannt, bei dem Kompensationselemente zur Beseitigung der Restüberkopplung bei gesperrtem Koppelpunkt vorgesehen sind. Dieses Koppelfeld benötigt jedoch erdsymmetrische Verstärker, was zu einem Mehraufwand an Versorgungsleitungen und Schaltelementen führt.

Aus der DE 32 15 176 A1, aus International switching Symposium, Montreal, CA, 21.-25. Sept. 1981, Session 21B, Paper 5, Seiten I-7 oder aus US A 35 50 087 ist es an sich bekannt den Ein- bzw. Ausgängen eines Koppelfeldes eine Entkopplungsstufe vorzuschalten bzw. nachzuschalten.

Die DE-A-24 51 728 zeigt einen Koppelpunkt mit einer Basisstufe am Eingang, der ausgangsseitig eine Emitterstufe nachgeschaltet ist. Der Basiswiderstand der Basisstufe ist in Form eines Transistors steuerbar ausgebildet. Je nach Steuerung dieses Transistors besitzt die Basisstufe einen geringen Durchlaß- oder einen hohen Sperrwiderstand. Die nachfolgende Emitterstufe trägt zur Sperrdämpfung des Koppelpunktes bei.

Aus der DE 29 17 989 A1 ist ein Koppelfeld mit FETs als Koppelpunkten bekannt. Die Koppelpunkte sind hier unsymmetrisch aufgebaut. Die Sperrwiderstände dieses FETs werden bekanntlich bei höheren Frequenzen durch die parasitären Kapazitäten zwischen ihren Elektroden bestimmt. Zur Verminderung dieses Nachteils wurde beim Koppelfeld der DE 29 17 989 A1 jeweils das Ausgangssignal einer Spalte über eine Verstärkerstufe auf die Bulk-Anschlüsse der FETs zurückgeführt. Die Lastkapazitäten können durch diese Maßnahme jedoch nur um etwa das Dreifache reduziert werden. Mit dieser Anordnung ist es nicht möglich, sehr viele Ausgänge miteinander zu verknüpfen. Außerdem ist die übertragbare Bitrate erheblich geringer als die, die mit Bipolartechnik erreichbar ist.

Aufgabe der Erfindung ist es daher, ein Breitbandkoppelfeld gemäß dem Oberbegriff des Patentanspruchs 1 so auszugestalten, daß eine hohe Bitrate bei ausreichend hoher Sperrdämpfung erreicht wird und die Signalverzögerungszeit durch die Koppelfeldmatrix nur wenig von der Zahl der pro Zeile durchgeschalteten Koppelpunkte abhängt.

Diese Aufgabe wird durch die kennzeichnenden Merkmale des Patentanspruchs 1 gelöst. Die Unteransprüche zeigen vorteilhafte Ausgestaltungen auf.

Die Erfindung zeichnet sich durch geringe Verlustleistung und wenig Komponenten (geringer Platzbedarf) aus. Bei unsymmetrischem Aufbau wird im Gegensatz zum Stromschalter-Koppelpunkt weder die Masse noch eine Referenzspannung am Koppelpunktschaltkreis benötigt. Es entfällt hier der Platzbedarf für die entsprechenden Leitungen. Durch die Seriengegenkopplung wird die Eingangsimpedanz des Koppelpunktes so hoch, daß die Signalverzögerungszeit durch die Matrix nur wenig von der Zahl der pro Zeile durchgeschalteten Koppelpunktschaltkreise abhängt. Das Breitbandkoppelfeld ist hoch integrationsfähig und ECL-kompatibel. Es gestattet beispielsweise die Durchschaltung von digitalen Videosignalen von mindestens 140 Mbit/s mit ausreichend kleiner Übersprechkopplung.

Anhand der Zeichnungen wird die Erfindung nun näher erläutert. Es zeigen.

Fig. 1 den prinzipiellen Aufbau des Koppelfeldes nach der Erfindung mit zeilenweise zu Gruppen zusammengefaßten Koppelpunkt-Schaltkreisen.

Fig. 2 einen Koppelpunktschaltkreis im Detail.

Fig. 3 einen detaillierten Stromlaufplan eines Koppelpunktschaltkreises mit eingangs- und ausgangsseitiger Entkopplungsstufe,

Fig. 4 einen Koppelpunktschaltkreis mit symmetrischem Stromschalter und

Fig. 5 einen Koppelpunktschaltkreis mit unsymmetrischem Stromschalter.

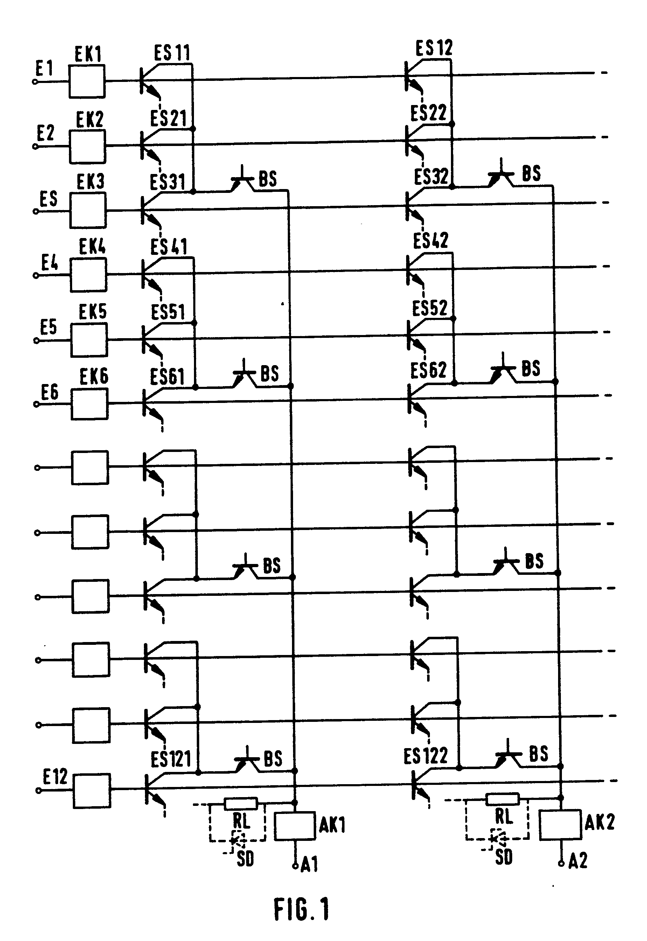

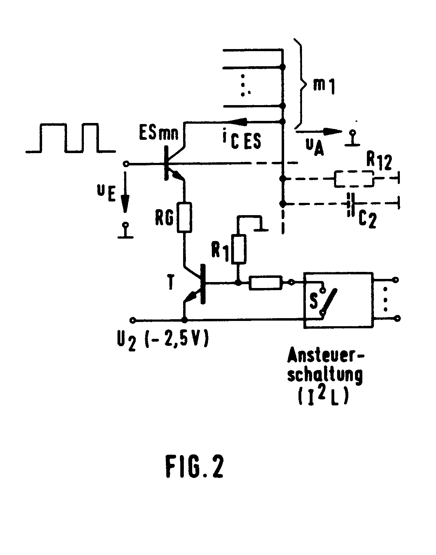

In Fig. 1 ist das Breitband-Koppelfeld, welches als mxn Schaltmatrix ausgebildet ist, im Prinzipaufbau dargestellt. In Zeilenrichtung werden über die Eingänge E1, E2, E3,... die durchzuschaltenden Signale, beispielsweise digitalisierte Videosignale, zugeführt. Die durchgeschalteten Signale werden in Spaltenrichtung über die Ausgänge A1, A2,... An abgenommen. Die Koppelpunktschaltkreise bestehen aus Emitterstufen ES11, ES12, ES13,... ES21, ES22, ES23,...; ES31, ES32, ES33,..., deren Eingänge (Basisanschlüsse) für jede Zeile miteinander verbunden sind. Den detaillierten Aufbau der Koppelpunkt-Schaltkreise mit Ansteuerung zeigt Fig. 2. Die m Koppelpunkte jeder Spalte sind hier zu $m_2$ Blöcken mit je $m_1$ Elementen zusammengefaßt ($m_2 = 1,...$ m). Beim Ausführungsbeispiel nach Fig. 1 ist $m_1 = 3$ und $m_2 = 4$ gewählt. Die verbundenen Ausgänge von je $m_1$ Koppelpunkten arbeiten auf eine selbstsperrende Basisstufe BSmn. Pro Spalte sind im speziellen Beispiel nach Fig. 1 vier Basisstufen nötig. Die Ausgänge dieser Basisstufen arbeiten wieder auf einen gemeinsamen Lastwiderstand $R_L$. Das

Optimum von $m_2$ (Zahl der Blöcke) hängt von den Randbedingungen ab.

Die Basisstufen BSmn jeder Spalte sind ausgangsseitig miteinander verbunden und führen zu einem gemeinsamen Lastwiderstand RL pro Spalte. Pro Zeile ist jeweils eine Entkopplungsstufe EK1, EK2, EK3,... am Eingang vorgesehen.

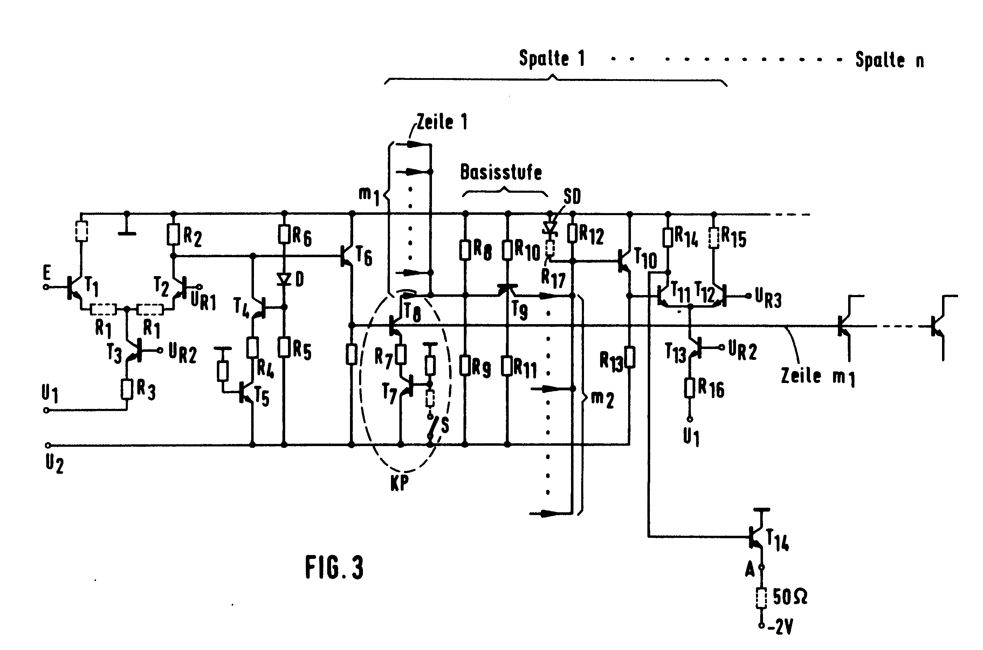

Ebenso weist jede Spalte eine Entkopplungsstufe AK1, AK2,... am Ausgang — A1, A2 — auf. Auf die spezielle Ausbildung der Entkopplungsstufen EKm und AKn wird bei der Beschreibung von Fig. 3 noch näher eingegangen.

In Fig. 2 ist ein einzelner Koppelpunktschaltkreis dargestellt. Einer Emitterstufe ESmn wird an ihrer Basis das durchzuschaltende Signal $u_E$ zugeführt. Im Emitterzweig von ESmn liegt eine Serienschaltung aus einem Gegenkopplungswiderstand RG und der Schaltstrecke eines Transistors T. Die Transistoren ESmn und T sind npn-Transistoren. Durch die Seriengegenkopplung der Emitterstufe mittels des Gegenkopplungswiderstandes RG wird die Eingangsimpedanz der Koppelpunktschaltkreise so hoch, daß die Signalverzögerungszeit durch die Matrix nur wenig von der Zahl der pro Zeile durchgeschalteten Koppelpunkte abhängt. Der Basis-Emitterstrecke des Transistors T ist ein Schalter S parallel geschaltet, mittels dem die Auswahl der Durchschaltungswege erfolgt. Bei geöffnetem Schalter S ist der Transistor T gesättigt und der Koppelpunkt durchgeschaltet. Der Schalter S als Bestandteil einer I²L-Logik wird durch eine Ansteuerschaltung (nicht dargestellt) aktiviert. Die Halteglieder sind ebenfalls nicht dargestellt. Ist der Schalter in Figur 2 dagegen geschlossen, so ist T gesperrt und damit der Koppelpunkt ausgeschaltet. Da der Strom durch $R_1$ sehr viel kleiner als $I_{CES}$ ist (z.B. $I_{CES}/5...I_{CES}/10$), so ist auch der Leistungsverbrauch erheblich geringer als beim eingeschalteten Koppelpunkt. Aber auch im eingeschalteten Zustand ist der Leistungsverbrauch relativ klein, da man, mit einer kleinen Versorgungsspannung $U_2$ und (trotz der hohen Bitrate) mit einem kleinen Schaltstrom $I_{CES}$ auskommt. Die Verlustleistung wird dadurch weiter reduziert, daß im eingeschalteten Zustand im Mittel nur der halbe Maximalstrom ($I_{CES}/2$) fließt im Gegensatz zu einem Stromschalter-Koppelpunkt. Am Emitter des Transistors T liegt eine Versorgungsspannung $U_2 = -2,5$ V.

Die Kollektoren von $m_1$ Emitterstufen ESmn sind, wie dies auch Fig. 1 zeigt, zusammengeschaltet. Zur Ansteuerung der nachfolgenden Basisstufe BSmn steht das Signal $u_A$ zur Verfügung.

Prinzipiell ist es möglich, jeder Emitterstufe ESmn eine Basisstufe BSmn nachzuschalten. Dies bringt jedoch keine zusätzlichen Vorteile, wie nachfolgend noch gezeigt wird. Darüber hinaus ist der Bauelementeaufwand erheblich. Man wird also immer bestrebt sein, soweit es die äußeren Randbedingungen zulassen, die Zahl der Blöcke, d.h. $m_2$, groß zu wählen.

In Fig. 3 ist ein Koppelpunktschaltkreis sowie eine ein- und ausgangsseitige Entkopplungsstufe in einem Stromlaufplan dargestellt. An den Eingang E in Zeilenrichtung schließt sich die in Figur 1 mit EKm bezeichnete Entkopplungsstufe an. Sie besteht aus einem Differenzverstärker — Transistoren $T_1$ und $T_2$ — sowie aus einem dem Differenzverstärker nachgeschalteten Emitterfolger (Kollektorstufe $T_6$). In der gemeinsamen Emitterleitung von $T_1$ und $T_2$ befindet sich der Transistor $T_3$ mit in Serie geschaltetem Widerstand $R_3$. Im Emitterzweig von T kann ein Gegenkopplungswiderstand $R_1$ eingefügt werden (gestrichelt) und ebenso ein Gegenkopplungswiderstand $R_1$ im Emitterzweig von $T_2$. Der im Emitterzweig von $T_3$ transistorferne Anschluß von Widerstand $R_3$ ist mit einer Versorgungsspannung $U_1$ beispielsweise $-5$V beaufschlagt. Die Kollektoren von $T_1$ und $T_2$ führen über Arbeitswiderstände an Massepotential. Der Arbeitswiderstand $R_2$ des Transistors $T_2$ liegt parallel zur Kollektor-Basisstrecke des Emitterfolgers $T_6$. Auf den Arbeitswiderstand von $T_1$ (gestrichelt) kann gegebenenfalls verzichtet werden, um die Eingangskapazität zu verringern. Die Entkopplungsstufe ist ECL-kompatibel. Durch die Gegenkopplung — $R_1$ — des Stromschalters kann die Eingangskapazität reduziert werden, so daß die externe Signalleitung nur wenig belastet wird. Die beiden Referenzspannungen $UR_1$ und $UR_2$ für die Transistoren $T_2$ und $T_3$ werden in der bei ECL-Schaltungen üblichen Weise durch einen internen Spannungsteiler erzeugt. Die Differenzverstärkerstufe — $T_1$, $T_2$ — wandelt den ECL-Pegel am Eingang E auf einen internen günstigeren Spannungspegel um. Mit Rücksicht auf ein kleines Produkt aus Schaltzeit und Verlustleistung wird dabei der Hub auf ca. 500 mV reduziert. Der Ausgang der Kollektorstufe $T_6$ ist mit dem eigentlichen Koppelpunktschaltkreis KP verbunden. Die Kollektorstufe $T_6$ dient zur Pegelverschiebung und zum Treiben der Zeilenleitung mit den angreifenden Koppelpunktschaltkreisen KP. Der Koppelpunktschaltkreis KP besteht aus der Emitterstufe $T_8$, in deren Emitterstromzweig ein Gegenkopplungswiderstand $R_7$ sowie in Serie dazu die Kollektor-Emitterstrecke des Transistors $T_7$ liegt. Der Koppelpunktschaltkreis wird durch ein Steuersignal aktiviert, welches den Schalter S öffnet (vgl. Beschreibung zu Fig. 2). Der Emitter von $T_7$ liegt an der Versorgungsspannung $U_2$, beispielsweise $-2,5$V. Wie das Ausführungsbeispiel der Fig. 3 zeigt, sind m Koppelpunkte einer Spalte, wie in Fig. 1, zu $m_2$ Blöcken mit je $m_1$ Elementen zusammengefaßt. Die verhältnismäßig große Spaltenkapazität $C_2$ (Figur 2) muß allein durch den eingeschalteten Koppelpunkt umgeladen werden. Für die Anstiegs bzw. Abfallzeit der Spannung $u_A$ am Lastwiderstand $R_{12}$ würde bei einem Sprung des Stromes $I_{CES}$ (Amplitude $I_{CES}$) näherungsweise gelten:

$$t_{r,f} \simeq \frac{\Delta U_A C_2}{I_{CES}} \simeq RC_2,$$

wobei $\Delta u_A$ der Spannungshub ist. Man erkennt, daß man, mit Rücksicht auf einen kleinen Schaltstrom $I_{CES}$ (d.h. kleine Verlustleistung), einen möglichst kleinen Spannungshub auf der Spalte anstreben muß, um eine ausreichend große Flankensteilheit (d.h. große maximale Bitrate) zu erreichen.

Weitere Vorteile eines kleinen Spaltenhubs $\Delta U_A$ sind:

a) kleinere Eingangskapazität der Koppelpunkte durch reduzierten Miller-Effekt, wodurch die Zeilenbelastung reduziert wird,

b) Verringerung der über die Kapazitäten $C_{CB}$ der ausgeschalteten Koppelpunkte auf die Spalte fließenden Störströme bei ungünstiger Phasenlage zum Signalstrom,

c) Verringerung der Störung parallel laufender Nachbarspalten.

Ein kleinerer Spaltenhub läßt sich dadurch erreichen, daß man zwischen Koppelpunkt und Lastwiderstand eine Basisstufe schaltet. Die Ausgänge der $m_1$ Emitterstufen sind deshalb mit einer selbstsperrenden Basisstufe (Transistor $T_9$) verbunden (Figur 3). Die Ausgänge der $m_2$ Basisstufen arbeiten auf den Lastwiderstand $R_{12}$. $R_{12}$ entspricht dem Lastwiderstand $R_L$ der Figur 1. Die Basisstufen ermöglichen steile Impulsflanken trotz hoher kapazitiver Belastung der internen Spalte und erhöhen — insbesondere für $m_2 > 1$ — die Sperrdämpfung. Durch den Spannungsteiler $R_8 — R_9$ wird die Vorspannung am Eingang der gesperrten Basisstufe gerade so weit abgesenkt, daß die Signalverzögerung bei langen Pulspausen nicht unzulässig stark ansteigt und die Basisstufe dennoch zuverlässig sperrt. Durch den Spannungsteiler $R_{10}—R_{11}$ kann der Abstand des Transistors $T_9$ von der Sättigungsgrenze bei Bedarf vergrößert werden.

Dem Lastwiderstand $R_{12}$ wird zweckmäßigerweise eine Schottky-Diode SD parallel geschaltet. Dies bringt den Vorteil einer Sperrdämpfungserhöhung bei leitender Basisstufe. Außerdem wird die Unsymmetrie der Spannungsübertragungskennlinie des Koppelpunktschaltkreises verringert, so daß z.B. das Pulspausenverhältnis bei einer 1010... Folge näher bei eins liegt. Zur Schottky-Diode SD kann bedarfsweise auch ein Widerstand $R_{17}$ (gestrichelt) in Serie geschaltet sein. Die Basisstufe $T_9$ und die Schottky-Diode SD lassen sich durch einen Schottky-Transistor miteinander vereinen.

Die ausgangsseitige Entkopplungsstufe besteht aus einer Emitterfolgerstufe zur Pegelverschiebung und Reduzierung der Belastung der Basisstufe — Transistor $T_{10}$—, einer Differenzverstärkerstufe — Transistoren $T_1$ und $T_{12}$—, in deren gemeinsamen Emitterleitung ein Transistor $T_{13}$ zur Emitterstromeinprägung ähnlich wie beim Differenzverstärker am Eingang eingefügt ist, und einer weiteren Emitterfolgerstufe — Transistor $T_{14}$. Mit dem Stromschalter, bestehend aus $T_{11}$, $T_{12}$ und $T_{13}$, werden die Impulse auf der Spalte regeneriert und etwa um den Faktor 2 auf die üblichen ECL-Hübe verstärkt. Der weitere Emitterfolger $T_{14}$ ist so dimensioniert, daß er abgeschlossene Leitungen treiben kann. Sind sämtliche Koppelpunkte einer Spalte ausgeschaltet, so liegt der zugehörige Ausgang auf dem L-Pegel. Dadurch können die einander entsprechenden Ausgänge A mehrerer Matrizen WIRED-OR verknüpft werden. Durch diese Erweiterung wird auf einfache Weise eine größere Matrix mit einer entsprechend höheren Anzahl von Eingängen (Zeilen) realisiert. Die ausgangsseitige Entkopplungsstufe ist daher auch ECL-kompatibel. Eine externe Last von 50 Ohm ist in Fig. 3 gestrichelt dargestellt.

Zwischen dem eingangsseitigen Differenzverstärker — $T_1$, $T_2$ — und der Kollektorstufe — $T_6$ — ist eine Kompensationsstufe angeordnet. Durch sie werden der Strom durch den Koppelpunktschaltkreis und damit der Spannungshub auf der internen Spalte (am Lastwiderstand $R_{12}$) näherungsweise unabhängig von Schwankungen der Versorgungsspannung $U_2$, der Temperatur und der Ausgangsspannung des Transistors $T_7$. Die Kompensationsstufe besteht aus zwei Transistoren $T_4$ und $T_5$, deren Kollektor-Emitterstrecken über einen Serienwiderstand $R_4$ in Reihe zueinander liegen. Der erste Transistor $T_4$ ist kollektorseitig mit dem Ausgang des Eingangsdifferenzverstärkers Transistoren — $T_1$, $T_2$ — und emitterseitig mit dem Serienwiderstand $R_4$ verbunden. Der zweite Transistor $T_5$ ist kollektorseitig mit dem Serienwiderstand $R_4$ verbunden und emitterseitig an die Versorgungsspannung $U_2$ gelegt. Der Basisanschluß des ersten Transistors $T_4$ ist über einen Spannungsteiler $R_5—R_6$ angeschlossen, der zwischen Masse und Versorgungsspannung liegt. In den dem Masseanschluß benachbarten Zweig des Spannungsteilers $R_5—R_6$ ist eine Diode D eingefügt. Durch geeignete Dimensionierung der Widerstände und Transistoren des Kompensationsnetzwerkes läßt sich der Einfluß einer Änderung des Kollektorbahnwiderstandes $r_{c7}$ von $T_7$ auf den Kollektorstrom $I_{CT8}$ weitgehend kompensieren. Hierzu dient der Transistor $T_5$ mit dem Bahnwiderstand $r_{c5}$, der wie Transistor $T_7$ in der Sättigung betrieben wird.

Für einen Stromschalter-Koppelpunkt (Differenzverstärkerstufe mit einem steuerbaren Schalter im gemeinsamen Emitterzweig) läßt sich die vorteilhafte Beschaltung mit einer Basisstufe am Ausgang und Parallelschaltung einer Schottky-Diode zur Erhöhung der Sperrdämpfung ebenfalls verwenden, allerdings mit einem Mehraufwand an Bauteilen und zusätzlich zugeführten Signalen (Referenzspannungen).

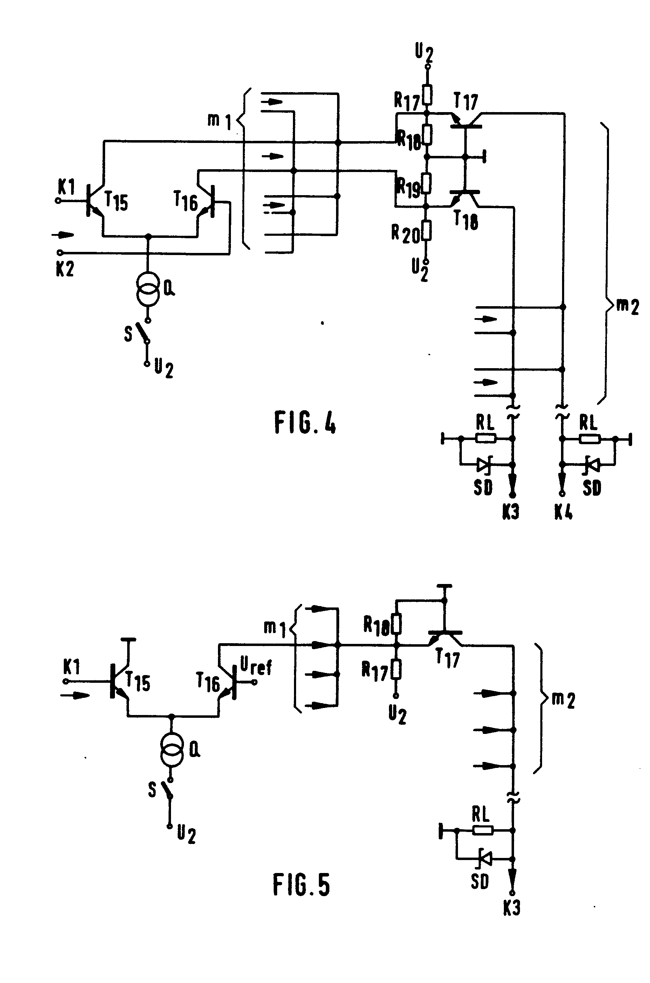

Schaltungsrealisierungen dieser Art sind in den Figuren 4 und 5 dargestellt. In Figur 4 besteht der Koppelpunktschaltkreis aus einem symmetrischen Stromschalter — Transistoren $T_{15}$, $T_{16}$ —. Das über eine ähnlich wie in Figur 3 aufgebaute eingangsseitige Entkopplungsstufe (nicht dargestellt) geführte Signal gelangt über die Klemmen K1 und K2 an die Basisanschlüsse der Transistoren T15 und T16. Im gemeinsamen Emitterzweig von T15 und T16 liegt eine Stromquelle Q, die über den an der Versorgungsspannung $U_2$ liegenden Schalter S, mit dem die Auswahl der durchzuschaltenden Koppelpunkte erfolgt, schaltbar ist. Die Kollektoren der Transistoren $T_{15}$ und $T_{16}$ sind mit jeweils einer Basisstufe $T_{17}$ bzw. $T_{18}$

verbunden. Diese beiden Basisstufen $T_{17}$, $T_{18}$, mit denen die entsprechenden $m_1$ Kollektoren anderer Koppelpunktschaltkreise eines Blockes ebenfalls verbunden sind, sind basisseitig mit Masse verbunden. Ein mit jeweils der Versorgungsspannung $U_2$ beaufschlagter Spannungsteiler, bestehend aus den Widerständen $R_{17} — R_{18}$, bzw. $R_{19} — R_{20}$, sorgt dafür, daß wie der Spannungsteiler $R_8—R_9$ in Figur 3 die Vorspannung am Eingang der gesperrten Basisstufen gerade so weit abgesenkt ist, daß die Signalverzögerung bei langen Pulspausen nicht unzulässig stark ansteigt und die Basisstufen dennoch zuverlässig sperren. $m_2$ solcher Doppelbasisstufen sind ausgangsseitig jeweils mit einem gemeinsamen Lastwiderstand $R_L$ beschaltet, dem eine Schottky-Diode SD parallel geschaltet ist. An die Ausgangsklemmen K3 und K4 schließt sich eine ausgangsseitige Entkopplungsstufe an, die ähnlich wie in Figur 3 aufgebaut sein kann, jedoch mit symmetrischen Ein- und Ausgängen.

Der Koppelpunktschaltkreis in Figur 5 ist ähnlich wie in Figur 4 aufgebaut, nun jedoch als unsymmetrischer Stromschalter. Nur der Transistor $T_{15}$ wird mit dem von der eingangsseitigen Entkopplungsstufe rührenden Signal angesteuert. Sein Kollektor ist auf Massepotential gelegt. Der Transistor $T_{16}$ wird basisseitig mit einer Referenzspannung $U_{ref}$ beaufschlagt. An seinen Kollektor wird die pro Block nur einmal vorhandene nachfolgende Basisstufe — $T_{17}$ — angeschlossen. $m_2$ solcher Basisstufen — $T_{17}$ — arbeiten auf einen gemeinsamen Lastwiderstand $R_L$ mit parallel geschalteter Schottky-Diode SD.

Wie Untersuchungen bei einer Bitrate von 280 Mbit/s (NRZ), einem internen Spannungshub von ca. 450 mW und ECL-kompatiblem Eingangs- und Ausgangspegel zeigten, beträgt die Verlustleistung für eine 16 × 16-Matrix ca. 880 mW und die Durchlaufzeit durch die gesamte Matrix ca. 3 ns. Mit der Bipolartechnik sind so schnelle hochintegrierte Koppelmatrizen mit relativ geringem Leistungsverbrauch realisierbar. Die Bitrate von 280 Mbit/s ist gegeben, wenn ein 140 Mbit/s Signal im CMI-Code übertragen werden soll.

**Patentansprüche**

1. Breitbandkoppelfeld in Matrixform, wobei die Koppelpunktschaltkreise aus jeweils einer Emitter- oder Differenzverstärkerstufe bestehen, deren Eingänge für jede Zeile miteinander verbunden sind, und in den Emitterstromzweig jeder Emitterstufe oder in den gemeinsamen Emitterzweig jeder Differenzverstärkerstufe ein Gegenkopplungswiderstand sowie ein mit einem Steuersignal zur Aktivierung des Koppelpunktes beaufschlagter Transistor eingefügt ist, und wobei die Ausgänge der Koppelpunktschaltkreise jeder Spalte auf einen gemeinsamen Lastwiderstand führen, dadurch gekennzeichnet, daß den Eingängen der Emitter- oder Differenzverstärkerstufen (ES mn; $T_8$; $T_{15}$, $T_{16}$) pro Zeile eine eingangsseitige Entkopplungsstufe (EK m; $T_1$, $T_2$) vorgeschaltet ist, daß den Emitter- oder Differenzverstärkerstufen (ES mn; $T_8$; $T_{15}$, $T_{16}$) einer oder mehrerer Zeilen pro Spalte eine selbstsperrende Basisstufe (BS mn; $T_9$; $T_{17}$, $T_{18}$) nachgeschaltet ist, daß die Ausgänge der Basisstufen (BS mn; $T_9$; $T_{17}$, $T_{18}$) jeder Spalte auf den gemeinsamen Lastwiderstand ($R_L$; $R_{12}$) der Spalte führen und daß diesem gemeinsamen Lastwiderstand ($R_L$; $R_{12}$) jeder Spalte eine ausgangsseitige Entkopplungsstufe (AK n; $T_{11}$, $T_{12}$) nachgeschaltet ist.

2. Breitbandkoppelfeld nach Anspruch 1, dadurch gekennzeichnet, daß die eingangsseitige Entkopplungsstufe (EK m) aus einer nichtlinearen übersteuerten Differenzverstärkerschaltung ($T_1$, $T_2$) besteht, der eine Kollektorstufe ($T_6$) nachgeschaltet ist.

3. Breitbandkoppelfeld nach Anspruch 2, dadurch gekennzeichnet, daß zwischen der Differenzverstärkerschaltung ($T_1$, $T_2$) und der Kollektorstufe ($T_6$) eine Kompensationsstufe ($T_4$, $T_5$) angeordnet ist, daß diese Kompensationsstufe ($T_4$, $T_5$) aus über einen Serienwiderstand ($R_4$) in Reihe zueinander liegenden Schaltstrecken zweier Transistoren ($T_4$, $T_5$) besteht, daß der erste dieser Transistoren ($T_4$) kollektorseitig mit dem Ausgang der Differenzverstärkerschaltung ($T_1$, $T_2$) und emitterseitig mit dem Serienwiderstand ($R_4$) verbunden ist, daß der zweite dieser Transistoren ($T_5$) kollektorseitig mit dem Serienwiderstand ($R_4$) und emitterseitig mit der Versorgungsspannung ($U_2$) verbunden ist, daß der Basisanschluß des ersten Transistors ($T_4$) über einen Spannungsteiler ($R_5$, $R_6$) zwischen Versorgungsspannung ($U_2$) und Masse angeschlossen ist, und daß in jenen Zweig des Sapnnungsteilers ($R_5$, $R_6$) eine Diode (D) eingefügt ist, der zum Masseanschluß führt.

4. Breitbandkoppelfeld nach einem der Ansprüche 1 bis 3, dadurch gekennzeichnet, daß parallel zum gemeinsamen Lastwiderstand ($R_L$, $R_{12}$) jeder Spalte eine Schottky-Diode (SD) angeordnet ist.

5. Breitbandkoppelfeld nach Anspruch 1, dadurch gekennzeichnet, daß die Basisstufen (BSmn; Tg) als Schottky-Transistoren ausgebildet sind.

6. Breitbandkoppelfeld nach einem der Ansprüche 1 bis 4, dadurch gekennzeichnet, daß dem gemeinsamen Lastwiderstand ($R_L$; $R_{12}$) jeder Spalte eine Emitterfolgerstufe ($T_{10}$) und dieser wiederum eine Differenzverstärkerstufe ($T_{11}$, $T_{12}$) mit einer weiteren Emitterfolgerstufe ($T_{14}$) am Ausgang nachgeschaltet ist.

**Revendications**

1. Champ de couplage à large bande en forme de matrice, où les circuits de commutation des points de couplage se composent chacun d'un étage à émetteur commun ou d'un étage amplificateur différentiel, dont les entrées constituant chaque ligne sont reliées ensemble, et où la branche d'émetteur de chaque étage à émetteur commun ou la branche commune d'émetteur de chaque étage amplificateur différentiel comprend une résistance de contre-réaction ainsi qu'un transistor recevant un signal de commande pour commuter le point de couplage, et où les sorties des circuits de commutation des points de couplage de chaque colonne sont reliées à une résistance de charge commune, caractérisé en ce que les entrées des étages à émetteur commun ou des étages amplificateurs différentiels (ESmn; $T_8$; $T_{15}$, $T_{16}$) sont dotés en amont pour chaque ligne d'un étage de découplage d'entrée (EKm; $T_1$, $T_2$), en ce que les étages à émetteur commun ou les étages amplificateurs différentiels (ESmn; $T_8$; $T_{15}$, $T_{16}$) d'une ou plusieurs lignes constituant une colonne sont dotés en aval d'un étage à base commune et autobloquant (BSmn; $T_9$; $T_{17}$, $T_{18}$), en ce que les sorties des étages à base commune (BSmn; $T_9$; $T_{17}$, $T_{18}$) de chaque colonne sont reliés à la résistance de charge commune (RL; $R_{12}$) de la colonne et en ce que cette résistance de charge commune (RL; $R_{12}$) de chaque colonne est suivie d'un étage de découplage de sortie (AKn; $T_{11}$, $T_{12}$).

2. Champ de couplage à large bande selon la revendication 1, caractérisé en ce que l'étage de découplage d'entrée (EKm) est constitué d'un circuit amplificateur différentiel linéaire fonctionnant en régime de saturation ($T_1$, $T_2$) suivi d'un étage à collecteur commun ($T_6$).

3. Champ de couplage à large bande selon la revendication 2, caractérisé en ce qu'est inséré entre le circuit amplficateur différentiel ($T_1$, $T_2$) et l'étage à collecteur commun ($T_6$) un étage de compensation ($T_4$, $T_5$), en ce que cet étage de compensation ($T_4$, $T_5$) se compose des circuits de commutation de deux transistors ($T_4$, $T_5$) raccordés entre eux par une résistance série ($R_4$), en ce que le premier de ces transistors ($T_4$) est relié côté collecteur à la sortie du circuit amplificateur différentiel ($T_1$, $T_2$) et côté émetteur à la résistance série ($R_4$), en ce que le second des ces transistors ($T_5$) est relié côté collecteur à la résistance série ($R_4$) et côté émetteur à la tension d'alimentation ($U_2$), en ce que la base du premier transistor ($T_4$) est relié à un diviseur de tension ($R_5$, $R_6$) situé entre la tension d'alimentation $U_2$ et la masse et en ce que la branche du diviseur de tension ($R_5$, $R_6$) qui mène à la masse comporte une diode (D).

4. Champ de couplage à large bande selon l'une des revendications 1 à 3, caractérisé en ce qu'une diode Schottky est montée en parallèle avec la résistance de charge commune (RL; $R_{12}$) de chaque colonne.

5. Champ de couplage à large bande selon la revendication 1, caractérisé en ce que les étages à base commune (BSmn; $T_9$) sont des transistors de Schottky.

6. Champ de couplage à large bande selon l'une des revendications 1 à 4, caractérisé en ce que la résistance de charge commune (RL; $R_{12}$) de chaque colonne est dotée en aval d'un étage émetteur suiveur ($T_{10}$) et en ce que celui-ci est à son tour doté en aval d'un étage amplificateur différentiel ($T_{11}$, $T_{12}$) avec un autre étage émetteur suiveur ($T_{14}$) à la sortie.

**Claims**

1. A broadband switching array in matrix form, with the crosspoint switching circuits each being composed of an emitter or differential amplifier stage whose inputs are connected together for each row and wherein a negative feedback resistor and a transistor charged with a control signal to activate the crosspoint are included in the emitter current branch of each emitter stage or in the common emitter branch of each differential amplifier stage, and wherein the outputs of the crosspoint switching circuits of each column lead to a common load resistor, characterised in that the inputs of the emitter or differential amplifier stages (ES mn; $T_8$; $T_{15}$, $T_{16}$) of each row have connected ahead of them an input decoupling stage (EK m; $T_1$, $T_2$); the emitter or differential amplifier stages (ES mn; $T_8$; $T_{15}$, $T_{16}$) of one or a plurality of rows per column are followed by a self-blocking base stage (BS mn, $T_9$; $T_{17}$, $T_{18}$); the outputs of the base stages (BS mn; $T_9$, $T_{17}$, $T_{18}$) of each column lead to a common load resistor ($R_L$; $R_{12}$) of each column; and this common load resistor (RL; $R_{12}$) of each column is followed by an output decoupling stage (AK n; $T_{11}$, $T_{12}$).

2. A broadband switching array according to claim 1, characterised in that the input decoupling stage (EK m) is composed of a non-linear, over-driven differential amplifier circuit ($T_1$, $T_2$) which is followed by a collector stage ($T_6$).

3. A broadband switching array according to claim 2, characterised in that a compensation stage ($T_4$, $T_5$) is disposed between the differential amplifier circuit ($T_1$, $T_2$) and the collector stage ($T_6$), with said compensation stage ($T_4$, $T_5$) being composed of the switching paths of two transistors ($T_4$, $T_5$) which are connected in series with one another via a series resistor ($R_4$); the first one of said transistors ($T_4$) has its collector connected with the output of the differential amplifier circuit ($T_1$, $T_2$) and its emitter with the series resistor ($R_4$); the second one of said transistors ($T_5$) has its collector connected with the series resistor ($R_4$) and its emitter with the supply voltage ($U_2$); the base terminal of the first transistor ($T_4$) is connected, via a voltage divider ($R_5$, $R_6$), between supply voltage ($U_2$) and ground; and a diode (D) leading to the ground terminal is included in each branch of the voltage divider ($R_5$, $R_6$).

4. A broadband switching array according to one of claims 1 through 3, characterised in that a Schottky diode (SD) is connected in parallel with the common load resistor ($R_L$, $R_{12}$) of each column.

5. A broadband switching array according to claim 1, characterised in that the base stages (BSmn; Tg) are designed as Schottky transistors.

6. A broadband switching array according to one of claims 1 through 4 characterised in that the common load resistor (RL; $R_{L2}$) of each column is connected to an emitter follower stage ($T_{10}$) and said emitter follower stage in turn is followed by a differential amplifier stage ($T_{11}$, $T_{12}$) which has a further emitter follower stage ($T_{14}$) connected to its output.

FIG.1

FIG.2

FIG. 3

FIG. 4

FIG. 5

4